# EUROPEAN PATENT APPLICATION

(11) **EP 3 331 253 A1**
(43) Date of publication of application: **06.06.2018**
(21) Application number: 16830140.6
(22) Date of filing: 24.05.2016
(51) Int. Cl.: H04R 3/00, A61G 5/10, B60L 3/00, B60Q 5/00, B60R 11/02, H03G 3/32

(54) **SOUND-VOLUME ADJUSTMENT APPARATUS**

(30) Priority: 30.07.2015 JP 2015150792
(71) Applicant: Aisin Seiki Kabushiki Kaisha, Kariya-shi, Aichi 448-8650 (JP)
(72) Inventor: NAGAMINE Noboru, Kariya-shi Aichi 448-8650 (JP); ANDO Mitsuhiro, Kariya-shi Aichi 448-8650 (JP); OCHIAI Hirotoshi, Kariya-shi Aichi 448-8650 (JP); KOBAYASHI Toshihiro, Kariya-shi Aichi 448-8650 (JP)
(74) Representative: Kramer Barske Schmidtchen Patentanwälte PartG mbB
(86) International application number: PCT/JP2016/065275
(87) International publication number: WO 2017/018035

(57) **Abstract**

A sound volume control apparatus includes a sound acquisition section provided in a moving body to be ridden by a human for acquiring a sound in a surrounding of the moving body, a storage section for storing a sound acquired by the sound acquisition section as sound data, a calculation section for calculating time change in volume of the sound acquired in a period from a predetermined first past timing to the present, with using the sound data, a sound volume setting section for setting a volume of an alarming sound based on result of the calculation in the calculation section, and an alarming section for effecting alarming in the volume set by the sound volume setting section.

## Description

### TECHNICAL FIELD

This disclosure relates to a sound volume control apparatus for controlling a volume of sound emitted from a moving body.

### RELATED ART

Conventionally, moving bodies such as electrically powered wheelchairs, electrically powered vehicles, hybrid vehicles, etc. have been widely used for providing convenience to users using them. However, as such moving bodies employ a motor utilizing electric energy as a power source thereof, when they travel, they seldom emit such a sound as makes a person present in its surrounding take notice of the presence of the moving bodies. Thus, the person may fail to take notice of an approaching moving body and can be surprised only when it comes into a close range. Then, it is conceivable to cause the moving body to emit a sound in order to notify its presence to the surrounding. It is also conceivable to notify a riding person of a traveling state of the moving body via a sound. However, the sound can be hardly audible in case the moving body is traveling in a noisy environment. Conversely, the sound can be a "noise" in the case of quiet environment. As techniques usable to solve such problems as above, there are techniques disclosed in documents identified below (e.g. Patent Documents 1-3).

A sound guidance apparatus disclosed in Patent Document 1 detects a sound present at its site of installment and extracts a noise signal present in two particular frequency ranges from noise signals relating to the detected noise. The apparatus measures any change that occurs in such extracted noise signal and tracks a minimal value of the noise signal. A plurality of tracking patterns are determined which determine response constants for increasing/decreasing a tracking control value for use in execution of tracking control. Then, 2 to 6 dB is added to an obtained tracking control value and the result is provided as an output sound volume.

A sound quality/volume control apparatus disclosed in Patent Document 2 detects a level of a sound source signal and a level of a noise signal by a predetermined cycle, respectively and compares the level of each signal with a level of the signal of the previous cycle and determines a level of a source sound signal and a level of a noise signal based upon the result of comparison. Further, the sound source signal is adjusted by a compensation value calculated based on the sound source signal level and the noise signal level thus determined.

An adaptive sound quality/volume control apparatus disclosed in Patent Document 3 analyzes a signal level of a sound source signal in each frequency range by a predetermined time interval and detects a maximum value of output for each frequency range by a time interval longer than the analysis time interval. The detected maximum value is retained; and with using this retained maximum value, a compensation amount for compensating ambient noise will be calculated for each predetermined time interval.

### Prior-Art Documents

### Patent Documents

Patent Document 1: Japanese Unexamined Patent Application Publication No. 2007-323451
Patent Document 2: Japanese Unexamined Patent Application Publication No. 2002-369281
Patent Document 3: Japanese Unexamined Patent Application Publication No. 2000-22471

### SUMMARY

### Problems to be Solved by Invention

The technique disclosed in Patent Document 1 calculates change in a minimal value of noise signal. This technique requires a long sampling period in the case of time zone originally less noisy. Thus, it is difficult for this technique to set an alarming sound level in a speedy manner. Also, in the case of the technique disclosed in Patent Document 2, with the arrangement of level comparison with the previous cycle, when there occurs a change in the level, it is not possible to appropriately judge whether this change is an idiopathic change or a cyclic change. Further, in the case of the technique disclosed in Patent Document 3, this technique calculates change in the maximum value. However, in a certain situation, the sound source is not constant. In such case, the compensation value cannot be calculated appropriately. Therefore, with the techniques disclosed in Patent Documents 1-3, appropriate alarming sound volume control according to the level of the ambient sound or noise is not possible.

Thus, there is a need for a sound volume control apparatus that automatically adjusts a volume of sound to be emitted from a moving body.

### Solution

According to a characterizing feature of a sound volume control apparatus relating to the present invention, the sound volume control apparatus comprises:
a sound acquisition section provided in a moving body to be ridden by a human for acquiring a sound in a surrounding of the moving body;
a storage section for storing a sound acquired by the sound acquisition section as sound data;
a calculation section for calculating time change in volume of the sound acquired in a period from a predetermined first past timing to the present, with using the sound data;
a sound volume setting section for setting a volume of an alarming sound based on result of the calculation in the calculation section; and
an alarming section for effecting alarming in the volume set by the sound volume setting section.

With the above-described characterizing feature, a sound which will be present in future in the surrounding of the moving body can be predicted from time change so far in the volume of the sound in the surrounding, and based on the result of this prediction, the volume of the sound to be emitted from the moving body can be set in advance. Thus, the volume of sound for alarming the surrounding of the moving body or the volume of sound for alarming the person riding on the moving body can be automatically adjusted in accordance with the volume of the sound present in the surrounding. Further, since this volume adjustment (control) of the alarming sound can be effected in a smooth manner according to the volume of the sound in the surrounding (ambient sound), it is possible to prevent occurrence of a person present in the surrounding of the moving body feeling unpleasant when hearing the sound issued from the alarming section and to prevent occurrence of the riding person's failing to hear the sound issued for him/herself. Furthermore, even if noise is contained in the sound data, since the volume of the alarming sound is set in accordance with time change so far in the volume of the surrounding sound, it is also possible to avoid inconvenience of the volume of the alarming sound becoming too large due to the noise.

Further preferably, there is provided a trough state determination section configured to determine it as a trough state in the time change if a state of the volume of sound being below an alarming sound audible threshold value has continued for a preset second period, the alarming sound audible threshold value being set in advance according to a volume, at least audible by the person, of the alarming sound to be emitted from the moving body; and
the alarming section effects the alarming if the trough state determination section determines the trough state.

With the above-described arrangement, the alarming can be effected at a timing that allows at least the person riding on the moving body to hear even a small sound easily. Therefore, failure by the person riding on the moving body to hear the alarming can be prevented. Further, since the alarming is effected under the above-described state, there is no need to increase the volume of the alarming sound excessively. Therefore, it is possible to prevent the sound used for alarming from being felt as noisy by a present present in the surrounding of the moving body.

Further, preferably, the trough state determination section stops the determination of trough state for a preset third period from the present in case the alarming section has effected the alarming.

With the above-described arrangement, even when a situation of the sound present in the surrounding of the moving body exceeding or failing short of the alarming sound audible threshold value continues to be present, the alarming can be stopped temporarily for the third period after execution of alarming.

Further, preferably, the alarming section effects the alarming if the volume of sound in the surrounding of the moving body is below the alarming sound audible threshold value.

With the above arrangement, it is possible to render the alarming sound readily audible by the person riding on the moving body.

Further, preferably, the alarming section effects the alarming in the volume set by the sound volume setting section when absence of the alarming sound has continued in a period from a preset fourth past timing to the present.

With the above-described arrangement, it is possible to prevent the person riding on the moving body from feeling too secure due to his/her inability to hear the alarming sound and to cause the person to take notice of the sound volume control apparatus being under operation.

Further preferably, there are provided:
a trend component calculation section for calculating a trend component indicative of varying trend in the volume of the sound which varies over time, with using the sound data;
a prediction section for predicting a volume of sound present in future in the surrounding of the moving body based on the trend component, in case a time change in the volume of the sound is greater than a preset predetermined value; and
the sound volume setting section sets the volume of the alarming sound based on the result of prediction by the prediction section.

With the above-described arrangement, the trend of variation so far in the volume of the sound in the surrounding of the moving body can be grasped easily. Therefore, by setting the volume of the sound to be emitted from the alarming section based on such trend, it is possible to improve the followability of the volume of the alarming sound relative to the ambient sound.

Further preferably, the trend component calculation section calculates two trend components different from each other; and
the sound volume setting section sets the volume of the alarming sound in accordance with the volume of the sound in the surrounding of the moving body which is predicted based on the two trend components.

With the above-described arrangement, prediction precision for the volume of sound in the surrounding of the moving body can be further enhanced. Thus, it becomes even easier for the volume of the sound emitted from the alarming section to follow the ambient sound.

Further preferably, the sound volume setting section sets the volume of the alarming sound based on a volume of a present sound acquired by the sound acquisition section and a volume of the present sound predicted in the past by the prediction section.

With the above-described arrangement, even when the volume of the sound emitted from the alarming section and set by the prediction significantly differs from the volume of the present sound in the surrounding of the moving body, the volume of the sound to be emitted from the alarming section can be corrected in a speedy manner.

Further, preferably, the sound volume setting section sets the volume of the alarming sound to a maximum value of rated output of the alarming section when the volume of alarming sound set based on the result of prediction by the prediction section exceeds the rated output of the alarming section.

With the above-described arrangement, after lapse of a predetermined period, before the alarming sound emitted from the alarming section becomes difficult to hear due to the sound present in the surrounding of the moving body, the presence of this moving body can be notified to the surrounding. Further, it also becomes possible to notify the riding person of the moving body that the sound in the surrounding of the moving body is expected to become very loud in future.

Further preferably, the sound volume setting section maintains the volume of the alarming sound at the present volume if the time change of the sound volume is below a preset predetermined value.

With the above-described arrangement, the expected volume of the surrounding sound of the moving body in future will not significantly from the volume of the sound emitted currently from the alarming section. Therefore, unnecessary calculation operation can be eliminated advantageously.

### BRIEF DESCRIPTION OF THE DRAWINGS

[Fig.1] is a view showing one example of a moving body,
[Fig. 2] is a block diagram showing a configuration of a sound volume control apparatus relating to a first embodiment,
[Fig. 3] is a view showing one example of sound data stored in a storage section relating to the first embodiment,
[Fig. 4] shows calculation result of a trend component by a trend component calculation section relating to the first embodiment,
[Fig. 5] is a block diagram showing a configuration of a sound volume control apparatus relating to a second embodiment,
[Fig. 6] is a view showing an alarming sound audible threshold value relating to the second embodiment,
[Fig. 7] is a view showing an example of alarming relating to the second embodiment,
[Fig. 8] is a view showing a trend component calculated by using a low-pass filter,
[Fig. 9] is a view showing a setting example for alarming sound relating another embodiment,
[Fig. 10] is a view showing an example of moving body in a variation example,
[Fig. 11] is a block diagram showing a configuration of a sound volume control apparatus,
[Fig. 12] is a view showing an example of alarming by an alarming device, and
[Fig. 13] is a view showing one example of an alarming cycle table.

### Embodiments

### 1. First Embodiment

A sound volume control apparatus relating to the present invention has a function of varying a volume of a sound to be emitted from a moving body according to a volume of an ambient sound (i.e. a sound present in the surrounding). Next, a sound volume control apparatus according to this embodiment will be explained.

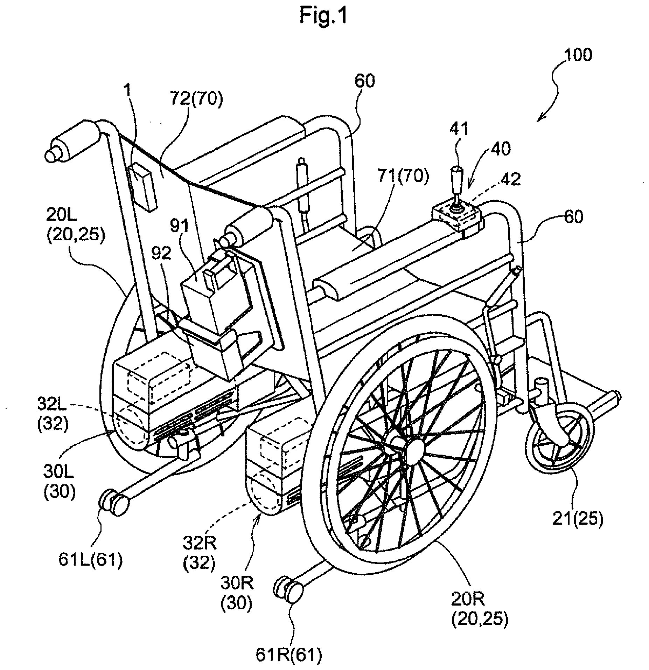

The sound volume control apparatus 1 is mounted on a moving body. Here, the term "moving body" refers to a vehicle on which a person can ride and corresponds, in this embodiment, to an electrically powered wheelchair 100. Thus, in the following discussion, the moving body will be explained as the electrically powered wheelchair 100. Fig 1 shows a perspective view of the electrically powered wheelchair 100 on which the sound volume control apparatus 1 is mounted. As shown in Fig. 1, the electrically powered wheelchair 100 includes a seat section 70, drive wheels 20, drive sections 30 and a control box 40.

The seat section 70 is mounted as being stretched in a vehicle width direction. The seat section 70 includes a seating portion 71 on which a passenger is to be seated, and a backrest portion 72 against which the passenger seated on the seating portion 71 rests his/her back. And, these portions, i.e. the seating portion 71 and the backrest portion 72 are attached to frames 60 provided on opposed outer sides in the vehicle width direction constituting a vehicle body. The electrically powered wheelchair 100 is foldable along the vehicle width direction for readiness of its storage and transport. Thus, the seating portion 70 is formed of a sheet of fabric, vinyl or the like that can be folded.

The electrically powered wheelchair 100 includes fourth wheels 25. These four wheels 25 consist of two casters 21 and two drive wheels 20. The casters 21 are provided on the front side in an advancing direction of the electrically powered wheelchair 100. Here, the term "advancing direction" means the direction in which the electrically powered wheelchair 100 travels forwardly. The casters 21 are provided as a pair of left and right casters disposed to be opposed to each other along the wheel width direction. Incidentally, in Fig. 1, illustration of the left caster 21 is omitted.

The drive wheels 20 are provided on the rear side in the advancing direction of the electrically powered wheelchair 100. The drive wheels 20 consist of a pair of left drive wheel 20L and right drive wheel 20R disposed to be opposed to each other along the outer sides in the vehicle width direction of the seating portion 70. In the following discussion, unless distinction therebetween is particularly needed, these will be referred to just as "drive wheels 20". The drive wheels 20 are wheels to which power for propelling the electrically powered wheelchair 100 is transmitted. On the other hand, in the present embodiment, the casters 21 receive no such power and are provided only for supporting a front portion of the electrically powered wheelchair 100. Further, in order to prevent collapsing of the seating portion 70 to the rear side in the advancing direction, the electrically powered wheelchair 100 is provided with roll-over prevention bars 61L, 61R which extend rearwardly of the drive wheels 20. In the following discussion, unless distinction therebetween is particularly needed, these will be referred to as just "roll-over prevention bars 61". These roll-over prevention bars 61 act as restricting means for preventing rollover to the rear side.

The drive sections 30 drive the respective drive wheels 20 by power supplied from a battery 91. The battery 91 stores in advance an amount of electric energy as power source for the electrically powered wheelchair 100 and is mounted via a holder 92 provided on the rear face of the backrest portion 72. Here, the respective drive wheels 20 mean the left drive wheel 20L and the right drive wheel 20R. For this reason, the drive sections 30 are provided in a pair to be able to drive the left drive wheel 20L and the right drive wheel 20R independently of each other. Here, the language "independently drive" is understood to mean that the left drive wheel 20L and the right drive wheel 20R can be driven at different rotational speeds and/or different rotational directions from each other. To this end, the drive sections 30 consist of a pair of left drive section 30L and right drive section 30R. In the following discussion, unless distinction therebetween is particularly needed, these will be referred to just as "drive sections 30".

The left drive section 30L includes a motor 32L for outputting a rotational force for rotating the left drive wheel 20L. Also, the right drive section 30R includes a motor 32R for outputting a rotational force for rotating the right drive wheel 20R. In the following discussion, unless distinction therebetween is particularly needed, these will be referred to as just "motors 32". The left drive section 30L and the right drive section 30R respectively receive electric energy outputted from the above-described battery 91 for driving the left drive wheel 20L and the right drive wheel 20R respectively and independently of each other.

The control box 40 includes a joystick 41 and a controller 42. The joystick 41 is mounted vertically under its neutral state extending perpendicularly upwards. From this state, as a passenger collapses it to a predetermined direction, the electrically powered wheelchair 100 can be guided in that direction. Further, according to an angle of the collapsing from the perpendicular upward, a moving speed is set. Therefore, the joystick 41 functions as an input device for inputting a passenger's intension. The controller 42 instructs an input to the joystick 41 to the drive sections 30 described above. Accordingly, the controller 42 functions as a speed instruction section for instructing a set moving speed to the drive sections 30. The left drive section 30L and the right drive section 30R constituting the drive section 30 drive the motor 32L and the motor 32R respectively in accordance with a drive instruction relating to traveling control inputted via the joystick 41.

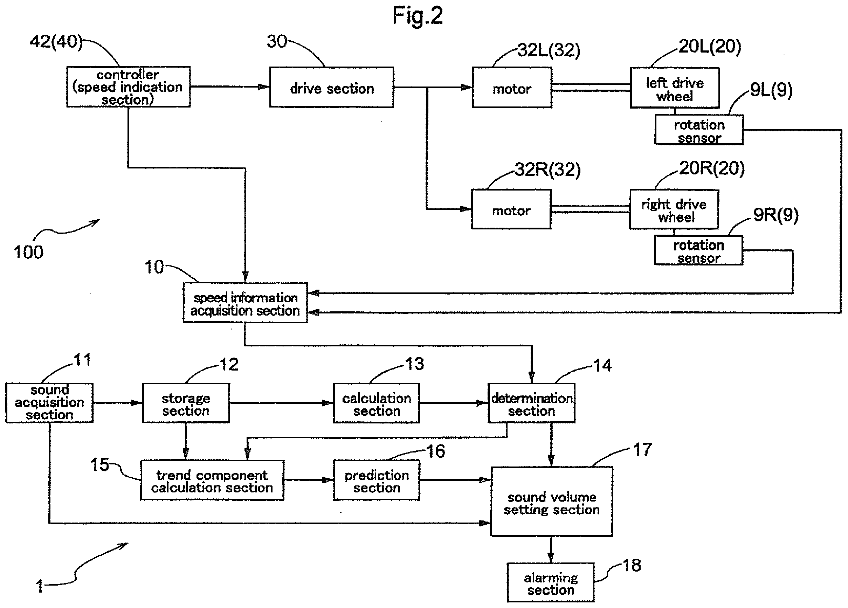

Next, the sound volume control apparatus 1 will be explained. Fig 2 is a block diagram showing a configuration of the sound volume control apparatus 1 relating to this embodiment. The sound volume control apparatus 1 includes respective functional sections consisting of a speed information acquisition section 10, a sound acquisition section 11, a storage section 12, a calculation section 13, a determination section 14, a trend component calculation section 15, a prediction section 16, a sound volume setting section 17, and an alarming section 18, and these functional sections are constituted of a hardware and/or software having a CPU as a core component thereof, in order to effect a processing relating to setting of a sound volume for alarming the presence of the electrically powered wheelchair 100. Incidentally, Fig. 2 shows the drive wheels 20, the drive sections 30, the motors 32 and the controller 42 described above also.

The speed information acquisition section 10 is mounted on the electrically powered wheelchair 100 and acquires speed information indicating of a moving speed of this electrically powered wheelchair 100. Such moving speed is detected based on a rotational speed of the drive wheels 20. Here, as described above, the electrically powered wheelchair 100 includes the left drive wheel 20L and the right drive wheel 20R which are driven independently of each other. For this reason, the left drive wheel 20L and the right drive wheel 20R are not always rotated in a same manner. Thus, in this embodiment, there are provided a rotation sensor 9L for detecting a rotational speed of the left drive wheel 20L and a rotation sensor 9R for detecting a rotational speed of the right drive wheel 20R. In the following discussion, unless distinction therebetween is particularly needed, these will be referred to just as "rotation sensors 9". The speed information acquisition section 10 receives transmission of detection results of rotational speeds of the left drive wheel 20L and the right drive wheel 20R obtained respectively by the rotation sensor 9L and the rotation sensor 9R and then detects (calculates) a moving speed of the electrically powered wheelchair 100 with using these rotational speeds. Then, the speed information acquisition section 10 transmits the detected moving speed as speed information to the determination section 14 to be described later.

Here, as described above, the controller 42 functions as a speed instruction section for instructing a moving speed according to an operation to the joystick 41 to the drive sections 30. Here, the speed information acquisition section 10 can alternatively be configured to acquire instruction content of moving speed by the controller 42 instead of calculating a moving speed with using the detection results of the rotation sensors 9 described above and transmit this moving speed included in the instruction content as the speed information to the determination section 14 to be described later.

The sound acquisition section 11 is mounted on the electrically powered wheelchair 100 and acquires an ambient sound (i.e. a sound present in the surrounding) of this electrically powered wheelchair 100. Here, an ambient sound of the electrically powered wheelchair 100 is understood to mean a sound audible by a person riding on the electrically powered wheelchair 100 and corresponds specifically to such sounds of other vehicle running on a road, an electric train, an airplane, etc. Needless to say, the sound includes also a sound of the motors 32 of the electrically powered wheelchair 100, a sound or noise heard from a building, a construction work site, etc. The sound acquisition section 11 can be constituted by using a microphone for picking up such sounds. The sound acquired by the sound acquisition section 11 is transmitted as "sound data" to the storage section 12 to be detailed next.

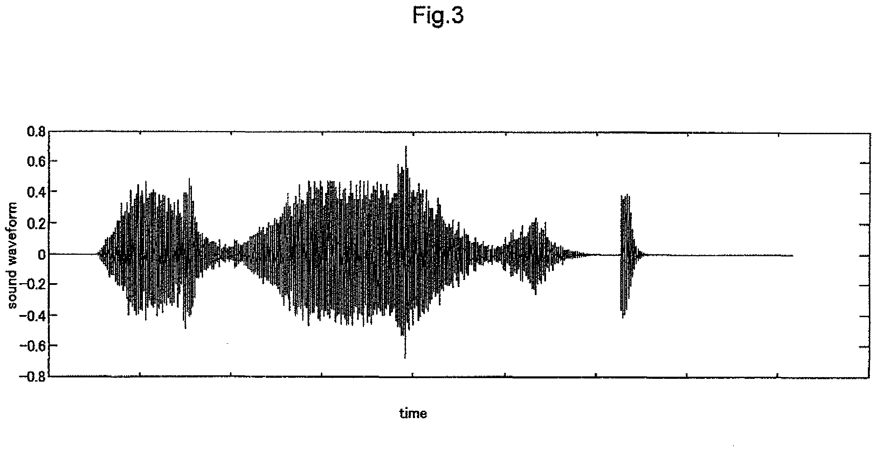

The storage section 12 stores a sound acquired by the sound acquisition section 11 as sound data. Specifically, the storage section 12 stores ambient sounds of the electrically powered wheelchair 100 as sound data chronologically. In this, advantageously, the sound data stored in the storage section 12 will be stored in association with time stamps which define times of acquisitions of the sound data. Fig. 3 shows one example of such sound data stored in the storage section 12. In the example shown in Fig. 3, the horizontal axis represents the time and the vertical axis represents a sound waveform. The sound data, as shown in Fig. 3, comprises a signal which oscillates in the positive and negative directions relative to a predetermined reference value.

The calculation section 13 uses the sound data stored in the storage section 12 for calculating a time change in the volume of the sound which has been acquired from a predetermined first past timing to the present. Here, the language "predetermined first past timing" means a preset predetermined timing in the past. Also, the language "time change in the volume of ambient sound" means a change that occurs over time in the ambient sound within a predetermined period. Specifically, it indicates a change of increase or decrease that has occurred in the volume of the present ambient sound. The calculation section 13 calculates such time change in the sound volume occurring from the predetermined first past timing to the present by making reference to the sound data from the predetermined first past timing to the present stored in the storage section 12. The result of this calculation by the calculation section 13 is transmitted to the determination section 14 detailed next.

The determination section 14 determines increase/decrease relationship of the time change in the ambient sound of the electrically powered wheelchair 100. Here, the language "increase/decrease relationship of the time change in the ambient sound relative to a traveling speed" means whether the ambient sound varies periodically or its volume is progressively increased or decreased in the course of traveling of the electrically powered wheelchair 100 at a predetermined constant speed.

Specifically, if there occurs periodical change in the ambient sound during traveling of the electrically powered wheelchair 100 at a predetermined speed, there occurs approximately no change in the average of the sound volume. Therefore, the determination section 14 determines that the time change of sound is small relative to the moving speed. Whereas, if the volume of the ambient sound is progressively increased during traveling of the electrically powered wheelchair 100 at a predetermined speed, this means not a sudden noise, but a progressive increase in the volume of the sound with an approximately constant slope. Thus, the determination section 14 determines that the time change of sound is large relative to the moving speed.

With such determinations as described above, if the time change of sound is small relative to the moving speed, it can be determined that no other moving body is present in the surrounding of the electrically powered wheelchair 100 and it can be predicted that the same periodical sound will continue for a while. On the other hand, if the time change of sound is large relative to the moving speed, it can be determined that another moving object emitting the large sound such as a train, a truck, etc. is approaching, and it can be predicted that the environment will move to a place where the sound for alarming the electrically powered wheelchair 100 is less audible.

The sound volume setting section 17 sets a volume of alarming sound based on the result of calculation by the calculation section 13. Here, the "alarming sound" corresponds to a sound for alarming presence of the electrically powered wheelchair 100 to the surrounding, a sound for notifying the passenger of the electrically powered wheelchair 100 of the traveling condition (e.g. the traveling speed,, presence/absence of any obstacle present in the surrounding, the traveling road condition, etc.). If the determination section 14 determines that a time change in the volume of the ambient sound of the electrically powered wheelchair 100 is below the present predetermined value, it can be predicted that the volume of the ambient sound of the electrically powered wheelchair 100 will not change significantly in future as described above. Hence, the sound volume setting section 17 maintains the level of the alarming sound at the present level. And, the sound volume set by the sound volume setting section 17 will be transmitted to the alarming section 18 to be described later. With this, in case the volume of the ambient sound acquired by the sound acquisition section 11 changes within a predetermined range for instance, the sound volume of the alarming sound can be made unchanged and maintained constant.

The alarming section 18 issues alarming to the surrounding of the electrically powered wheelchair 100 and/or the riding person of the electrically powered wheelchair 100 by the sound volume set by the sound volume setting section 17, that is, the same level as before. Preferably, such alarming section 18 is constituted by using e.g. a speaker.

The trend component calculation section 15 uses the sound data for calculating a trend component indicative of a trend of change in sound volume which varies over time. Here, the language "a trend of change in sound volume which varies over time" indicates a change of change in the sound volume, which is referred to as "trend component" in this embodiment. This trend component can be calculated by e.g. the moving average method, the average weighted method, etc. Based on such trend component, it becomes possible to specify a trend of change in the ambient sound of the electrically powered wheelchair 100. The calculation of the trend component by the trend component calculation section 15 can be effected for each occasion of storage of sound data in the store section 12 or can be effected when the prediction section 16 to be described later predicts a future sound volume.

Here, advantageously, the trend component calculation section 15 calculates the trend component by modeling the sound data into a smooth curve with using preset smoothing parameter. As such smoothing parameter, a known HP (the Hodrick-Prescott) filter, the spline smoothing, the state-space modeling can be employed.

Further, preferably, the trend component calculation section 15 sets a smoothing parameter for use in the calculation of such trend component in accordance with a trend component at issue. Namely, in case a period of small change in the trend component continues (periodical variation component or large irregular variation component), a gentle smoothing parameter can be used advantageously. With this arrangement, while the electrically powered wheelchair 100 is traveling on a pedestrian road, if many other vehicles are traveling in congestion one after another continuously right beside it, an optimal sound volume averaged for a longer period time can be set with reduction in the trackability of the alarming sound relative to the sounds of these other vehicles.

In the instant embodiment, the trend component calculation section 15 calculates two trend components different from each other. Here, the language "two trend components different from each other" means two trend components which differ from each other in their smoothness. And, the "smoothness" means a degree of the curve depicted by the trend component, namely, its curvature of radius. For instance, in the case of calculation of the trend component by the moving average method, by making periods of sound data acquisition which constitute a parameter different from each other, such two mutually different trend components can be calculated. In the instant embodiment, the two trend components correspond to a first trend component calculated with using sound data for a predetermined period and a second trend component calculated with using sound data for a period longer than the predetermined period.

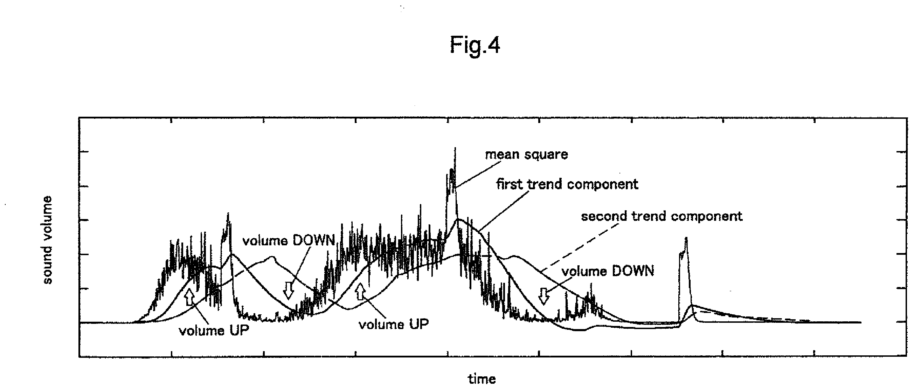

Fig. 4 shows a first trend component and a second trend component which were calculated by the trend component calculation section 15. Firstly, the trend component calculation section 15 calculates a mean square value of the sound data stored in the storage section 12 as shown in Fig. 3. Fig. 4 shows result of this calculation also. Then, the trend component calculation section 15 uses this calculation result of mean square value to calculate the first trend component and the second trend component.

The prediction section 16 predicts a future sound volume in the surrounding of the electrically powered wheelchair 100 based on the trend components, in case the time change of the sound volume is greater than the preset predetermined value. As described above, "in case the time change of the sound volume is greater than the preset predetermined value", it is believed that some moving body emitting a large sound is approaching the electrically powered wheelchair 100, so it is predicted that the situation will enter an environment where the sound of alarming the presence of the electrically powered wheelchair 100 becomes less audible. Thus, the prediction section 16 predicts the future volume of the ambient sound in the surrounding of the electrically powered wheelchair 100, based on the relationship between the first trend component and the second trend component.

The prediction section 16 predicts that the volume of the ambient sound in the surrounding of the electrically powered wheelchair 100 will increase in future, if the first trend components exceeds the second trend component when the first trend component is smaller than the second trend component. On the other hand, the prediction section 16 predicts that the volume of the ambient sound in the surrounding of the electrically powered wheelchair 100 will decrease in future, if the first trend component falls short of the second trend component when the first trend component is greater than the second trend component. Such prediction result of the prediction section 16 is transmitted to the sound volume setting section 17.

Upon receipt of the prediction result from the prediction section 16, the sound volume setting section 17 sets a volume of alarming sound, based on tis prediction result from the prediction section 16. Namely, the sound volume setting section 17 sets a volume of the alarming sound, based on a volume of the sound in the surrounding of the electrically powered wheelchair 10 predicted based on the two trend components. Specifically, if the prediction section 16 predicts that the volume of the ambient sound of the electrically powered wheelchair 100 will increase in future, the sound volume setting section 17 sets the volume of the alarming sound to be greater than the present volume. Namely, as shown in Fig. 4, if, for instance, the first trend component exceeds the second trend component, the sound volume setting section 17 sets the volume of the alarming sound to be greater than the present volume (volume UP). Whereas, if the prediction section 16 predicts that the volume of the ambient sound of the electrically powered wheelchair 100 will become smaller in future, the sound volume setting section 17 sets the volume of the alarming sound to be smaller than the present volume. Namely, as shown in Fig. 4, if, for instance, the first trend component falls short of the second trend component, the sound volume setting section 17 sets the volume of the alarming sound to be smaller than the present volume (volume DOWN).

With the above-described setting of the volume of alarming sound by the sound volume setting section 17, alarming can be effected so that the alarming sound indicative of the presence of the electrically powered wheelchair 100 will not be difficult to hear, to the surrounding which is noisy. Conversely, when the surrounding is not noisy, the alarming can be effected such that the alarming sound indicative of the presence of the electrically powered wheelchair 100 will not be noisy nuisance. Further, even when the surrounding is nosy, the alarming can be effected for the person riding on the electrically powered wheelchair 100 in such a manner the sound indicative of e.g. traveling condition will not be inaudible. And, when the surrounding is not noisy, the alarming can be effected so as not to be noisy nuisance to the surrounding of the electrically powered wheelchair 100.

Further, advantageously, the sound volume setting section 17 sets a volume of the alarming sound, based on the present actual sound volume acquired by the sound acquisition section 11 and a predicted present sound volume predicted previously by the prediction section 16. Here, "the present actual sound volume acquired by the sound acquisition section 11" means the volume of the ambient sound at the site where the electrically powered wheelchair 100 is currently present. Also, "a predicted present sound volume predicted previously by the prediction section 16" means a volume of present sound predicted at a certain past timing by the prediction section 16 as a future sound volume. Then, if the prediction result of the prediction section 16 is agreement with the present actual sound volume, the sound volume setting section 17 maintains the volume of the alarming sound at the presently set volume. On the other hand, if the present sound volume falls short of the prediction result of the prediction section 16, the sound volume setting section 17 decreases the set alarming sound volume. Furthermore, if the present sound volume exceeds the prediction result of the prediction section 16, the sound volume setting section 17 increases the set alarming sound volume. With the sound volume setting by the sound volume setting section 17 described above, even when an error has occurred in the prediction by the prediction section 16 or sudden change has occurred in the volume of the ambient sound, the alarming sound can be set appropriately according to the volume of the ambient sound.

### 2. Second Embodiment

Next, a second embodiment of the sound volume control apparatus 1 will be explained. In the first embodiment described above, it was explained that the sound volume control apparatus 1 sets a volume of alarming sound according to a time change in sound volume acquired in a period from a predetermined past time to the present. The sound volume control apparatus 1 relating to the second embodiment differs from the first embodiment in that the apparatus changes also a timing of sound alarming according to a time change in sound volume acquired in a period from a predetermined past time to the present. In the following, the difference from the first embodiment will be mainly explained.

The sound volume control apparatus 1 relating to this embodiment is also mounted on the electrically powered wheelchair 100 (an example of "moving body") as shown in Fig.1, like the first embodiment. The electrically powered wheelchair 100 is same as that of the first embodiment, so explanation thereof will be omitted in this embodiment.

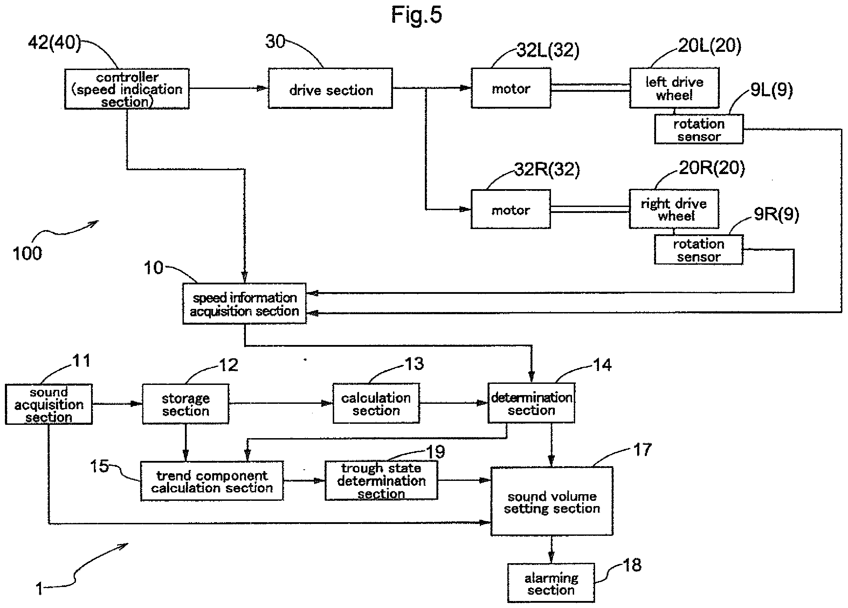

Fig. 5 is a block diagram schematically showing a configuration of the sound volume control apparatus 1 relating to this second embodiment. The sound volume control apparatus 1 according to this embodiment includes respective functional sections consisting of a speed information acquisition section 10, a sound acquisition section 11, a storage section 12, a calculation section 13, a determination section 14, a trend component calculation section 15, a trough state determination section 19, a sound volume setting section 17, and an alarming section 18, and these functional sections are constituted of a hardware and/or software having a CPU as a core component thereof in order to execute a process relating to setting of a timing of sound alarming from the electrically powered wheelchair 100. Incidentally, Fig. 5 shows the drive wheels 20, the drive sections 30, the motors 32 and the controller 42 also, like the first embodiment.

The sound acquisition section 11, the storage section 12, the calculation section 13, the determination section 14 and the trend component calculation section 15 are same as those in the first embodiment, so explanation thereof will be omitted. The trough state determination section 19 determines it as a trough state in time change, if a state of the sound volume below an alarming sound audible threshold value has continued for a preset second period. The alarming sound audible threshold value is set in advance according to a sound volume with which at least a person can hear an alarming sound emitted from the electrically powered wheelchair 100. Here, the language "an alarming sound emitted from the electrically powered wheelchair 100" means a sound emitted for alarming, from the alarming section 18, a surrounding situation of the electrically powered wheelchair 100 to a person riding on this electrically powered wheelchair 100. Therefore, the language "a sound volume audible by a person" means a volume of a sound emitted from the alarming section 18 which is audible by a person riding on the electrically powered wheelchair 100 against noise present in the surrounding. And, the language "audible" means the person riding on the electrically powered wheelchair 100 can recognize emission of a sound per se (the fact of some sound being emitted from the alarming section 18). Then, respecting the volume of the alarming sound to be emitted from the alarming section 18, the alarming sound audible threshold value is set as a index for discriminating an audible sound and an inaudible sound for the person riding on the electrically powered wheelchair 100. In the above, the language "a preset second period" means a period set for allowing the trough state determination section 19 to determine a trough state. Incidentally, the above-described "a sound volume audible by a person" can be set also as a sound volume by a degree allowing the distinction of information in case e.g. the sound volume control apparatus 100 transmits information based on the kind of sound, the timing of the emission of the alarming sound, etc.

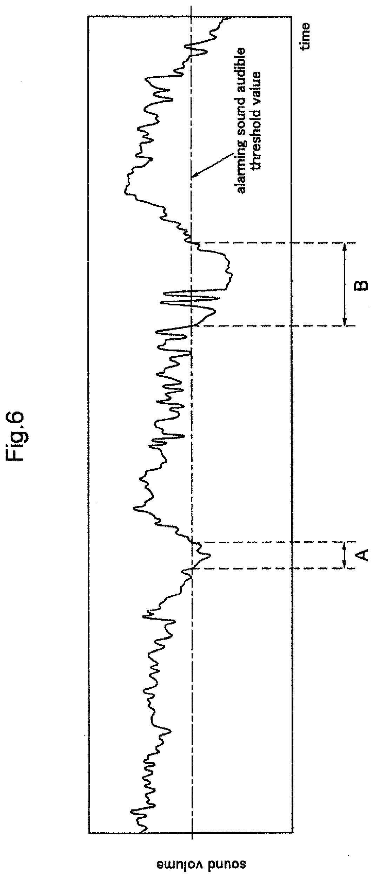

Fig. 6 shows such alarming sound audible threshold value and result of calculation of time change in the volume of sound acquired by the sound acquisition section 11. Incidentally, the time change in sound volume shown in Fig. 6 can indicate simply a time change in sound volume or can also be a time change obtained by the two trend components, like the first embodiment. On the other hand, the alarming sound audible threshold value is set in advance based on a volume of sound audible by a person riding on the electrically powered wheelchair 100. Therefore, in Fig. 6, in case the sound volume is greater than the alarming sound audible threshold value, it is difficult for the person riding on the electrically powered wheelchair 100 to hear the alarming sound emitted from the sound volume control apparatus 1. Whereas, in case the sound volume is smaller than the alarming sound audible threshold value, it is easy for the person riding on the electrically powered wheelchair 100 to hear the alarming sound emitted from the sound volume control apparatus 1.

The trough state determination section 19 determines it as a trough state if a state of sound volume below the alarming sound audible threshold value has continued for the preset second time (for at least a period shorter than a period relating to interval A) as shown by interval A in Fig. 6 for instance. Further, alternatively, as indicated by interval B in Fig. 6, if the state of sound volume below the alarming sound audible threshold value has continued for the second period (for a period at least shorter than interval A) and then becomes greater than the alarming sound audible threshold value temporarily and then drops below the alarming sound audible threshold value again, the trough state determination section 19 can determine this only as a trough state. Or, these intervals can be generically interpreted as a trough state. The determination result of the trough state determination section 19 is transmitted to the sound volume setting section 17.

Incidentally, still alternatively, the trough state determination section 19 can be configured to determine it as a trough state if the state of a sound volume below the alarming sound audible threshold value continues for a preset period and then the time change in the sound volume has a rising trend.

Upon receiving the determination result from the trough state determination section 19, the sound volume setting section 17 sets a volume of alarming sound. In this, since the volume of ambient sound is smaller than the alarming sound audible threshold value in the trough state, the sound volume setting section 17 will set the volume of alarming sound to such a level that does not cause audible nuisance for the person riding on the electrically powered wheelchair 100. Such sound volume can be set in advance.

When the trough state determination section 19 has determined a trough state, the alarming section 18 will effect alarming to the surrounding of the electrically powered wheelchair 100 or the person riding on the electrically powered wheelchair 100 by the volume set by the sound volume setting section 17. Namely, the alarming section 18 effects alarming when the volume of sound in the surrounding of the electrically powered wheelchair 100 is below the alarming sound audible threshold value. Preferably, the alarming section 18 is constituted of a speaker for example.

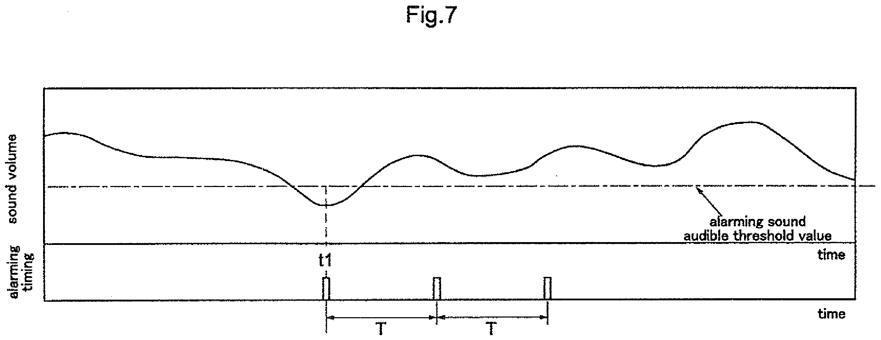

Here, alternatively, the alarming section 18 can effect alarming continuously as long as the volume of the ambient sound of the electrically powered wheelchair 100 stays below the alarming sound audible threshold value. Further alternatively, as shown in Fig. 7, the alarming can be effected for each predetermined period T (periodically), with reference to a timing (timing t1 in the illustration of Fig. 7) at which the volume of the ambient sound of the electrically powered wheelchair 100 dropped below the alarming sound audible threshold value. Still alternatively, even in the case of periodical alarming, if the trough state was detected by different cycles, alarming can be effected for each predetermined period T with reference to a new trough state.

Further, as shown in interval B in Fig. 6, it may sometimes happen that the sound volume exceeds and drops below the alarming sound audible threshold value in repetition. In case the alarming section 18 is configured to effect alarming under a trough state as described above, the alarming from the alarming section 18 will be effected and stopped in repeated alternation in accordance with change in the sound volume. Then, it is possible to arrange such that if the alarming section 18 effects alarming, the tough state determination section 19 stops trough state determination for a preset third period from the present.

Further, the alarming section 18 can be alternatively configured to effect alarming by the volume set by the sound volume setting section 17 in case state of no sound alarming has continued for a period from a preset fourth past time to the present. Namely, it is possible to arrange such that if a period determined not as a trough state by the trough state determination section 19 has continued longer than a predetermined period, the sound volume setting section 17 temporarily increases the volume of the alarming sound and the alarming section 18 effects alarming by this increased sound volume. Further, in case the sound volume has been increased temporarily, this sound volume can be returned to the original volume after lapse of the predetermined period.

### 3. Other Embodiments

In the foregoing respective embodiments, it was explained that the sound volume setting section 17 sets a volume of alarming sound based on prediction result of the prediction section 16. Alternatively, however, the sound volume setting section 17 can set the volume of alarming sound to the surrounding based on calculation result by the calculation section 13 on time change in the volume of ambient sound of the electrically powered wheelchair 100. In this case, the sound volume control apparatus 1 can omit the trend component calculation section 15 and the prediction section 16.

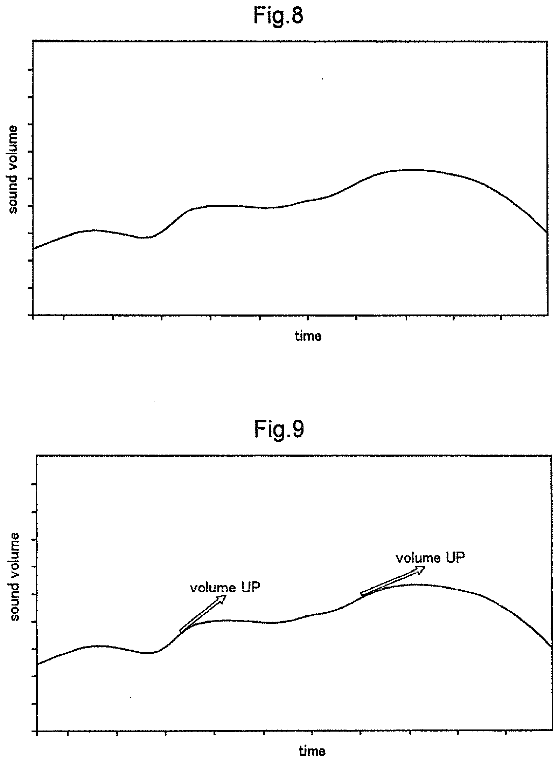

In the first embodiment described above, it was explained that the trend component calculation section 15 calculates two mutually different trend components and the sound volume setting section17 sets a volume of alarming sound according to the volume of ambient sound of the electrically powered wheelchair 100 predicted based on such two trend components. Alternatively, it is possible to arrange such that the trend component calculation section 15 effects serial calculation of one kind of trend component and the sound volume setting section 17 sets the volume of alarming sound based on this one kind of trend component. Namely, in this case, the trend component calculation section 15 calculates a mean square as shown in Fig. 4 with using sound data stored in the storage section 12 and effects a predetermined filtering processing (e.g. a processing using a low pass filter) on this mean square data to calculate a trend component. Such trend component is shown in Fig. 8. Then, the sound volume setting section 17 can set the volume of alarming sound according to such trend component (according to the curve of the trend component). With this arrangement, it becomes possible to cause the volume of alarming sound not to follow a suddenly occurring noise. Consequently, it becomes possible to vary the sound volume in a smooth and gentle manner.

Further, in the case of setting the volume of alarming sound according to such trend component shown in Fig. 8, if the slope of the trend component is steep, then, as illustrated in Fig. 9, it may be predicted that the change in the volume of the ambient sound is large, so the volume of alarming sound is increased. That is, as illustrated in Fig. 9, in case the slope of the trend component is large, advantageously, the sound volume setting section 17 can provide greater increase (volume UP) than the case of setting the alarming sound volume according to the curve of the trend component.

Moreover, it is also possible to arrange such that the sound volume control apparatus 1 specifies a type of sound source of the sound acquired by the sound acquisition section 11 and the sound volume setting section 17 sets the volume of alarming sound according to the specified sound source. Namely, if the sound acquired by the sound acquisition section 11 originated from e.g. a train or a truck, the sound volume control apparatus 1 can vary the volume of alarming sound more largely (volume UP) than the case of varying the sound volume according to the curve of the trend component.

In the first embodiment, it was explained that the sound volume setting section 17 sets the volume of alarming sound based on prediction result of the prediction section 16. Alternatively, the sound volume setting section 17 can be configured to set the volume of alarming sound to a maximum value of rated output in case the volume of alarming sound set by the prediction result of the prediction section 16 exceeds a rated output of the alarming section 18 (e.g. a rated output of a speaker). With this arrangement, it is possible to notify the surrounding of the electrically powered wheelchair 100 of the presence of this electrically powered wheelchair 100 before the alarming sound emitted from the alarming section 18 becomes less audible by the ambient sound of the electrically powered wheelchair 100, after lapse of a predetermined period. Further, for the person riding on the electrically powered wheelchair 100, it is possible to notify in advance that the ambient sound of the electrically powered wheelchair 100 will become very large in future. At this time, as it is predicted that the alarming sound emitted from the alarming section 18 will become less audible by the ambient sound of the electrically powered wheelchair 100 after lapse of the predetermined period, it is possible to configure the alarming section 18 to effect the alarming not by sound alarming, but by light or vibration, etc. Further, the alarming section 18 can be configured also to effect the alarming by light, vibration, etc. in addition to the sound alarming.

In the foregoing embodiments, it was explained that the sound volume setting section 17 sets the volume of the alarming sound based on the present volume of the sound acquired by the sound acquisition section 11 and the present volume of sound predicted in in the past by the prediction section 16. Alternatively, the sound volume setting section 17 can be configured not to control the volume of the alarming sound based on the volumes of these two sounds.

In the first embodiment described above, it was explained that the sound volume setting section 17 maintains the volume of sound for alarming presence of the electrically powered wheelchair 100 to the surrounding at the present volume in case the time change of the sound value is below the preset predetermined value. Alternatively, the sound volume setting section 17 can be configured to make the volume of sound for alarming presence of the electrically powered wheelchair 100 to the surrounding smaller than the present volume, in case the time change of the sound value is below the preset predetermined value.

In the second embodiment described above, it was explained that the trough state determination section 19 sops determination of trough state for the preset third period from the present, in case the alarming section 18 effected alarming. Alternatively, the tough state determination section 19 can be configured to continue its determination of trough state, even in case the alarming section 18 effected alarming.

In the second embodiment described above, it was explained that the alarming section 18 effects alarming when the ambient sound of the electrically powered wheelchair 100 is below the alarming sound audible threshold value. Alternatively, in case the alarming is effected periodically based on a timing of determination of a trough state, it can be arranged such that alarming after lapse of the predetermined period will be effected also when the volume of the ambient sound of the electrically powered wheelchair 100 is not below the alarming sound audible threshold value.

In the second embodiment described above, it was explained that the alarming section 18 effects the alarming by the volume set by the sound volume setting section 17 in case the state of no alarming sound emission has continued for the period from the preset fourth past time to the present. Alternatively, the alarming section 18 can be configured not to effect the alarming even in case the state of no alarming sound emission has continued for the period from the preset fourth past time to the present. Further alternatively, the alarming section 18 can be configured to vary the alarming sound audible threshold value in case the state of no alarming sound emission has continued for the period from the preset fourth past time to the present. Specifically, it can be arranged such that the alarming sound audible threshold value will be set larger if e.g. a safe traveling condition can be retained in future also. Conversely, it can be arranged such that the alarming sound audible threshold value will be set smaller so as not to divert attention.

In the foregoing embodiments, the electrically powered wheelchair 100 was cited as an example of the moving body. However, the moving body can be any other vehicle as long as a person can ride on it. Specifically, it can be an electrically powered vehicle, a hybrid vehicle, a "Personal Mobility", a bicycle, a non-electrically powered wheelchair, etc.

### 4. Variations

Next, variations comprising partial changes in the functions of the above-described sound volume control apparatus 1 will be explained.

Conventionally, moving bodies such as electrically powered wheelchairs, electrically powered vehicles, hybrid vehicles, etc. have been widely used for providing convenience to users using these. However, as such moving bodies employ a motor utilizing electric energy as a power source thereof, when they travel, they seldom emit such a sound as makes a person present in its surrounding take notice of the presence of the moving bodies. Thus, the person may fail to take notice of an approaching moving body and can be surprised only when it comes into a close range. Then, the art has studied a technique for notify presence of a moving body to its surrounding (e.g. Japanese Unexamined Utility Model Publication No. Hei, 6-70098 and Japanese Unexamined Patent Application Publication No. 2008-1124).

In the case of a dummy sound generation apparatus for an electrically powered automobile disclosed in Japanese Unexamined Utility Model Publication No. Hei, 6-70098, if a vehicle speed of an electrically powered automobile, a rotational speed of a motor, a stepping-on operation on an accelerator pedal, a direction of a turning signal, a steering direction of a steering wheel, etc. is detected as a traveling condition, a dummy sound of e.g. an engine sound of an engine powered automobile, a music, a chime, etc. according to this traveling condition will be emitted for alarming to the outside of the vehicle.

In the case of a car-mounted sound generation apparatus disclosed in Japanese Unexamined Patent Application Publication No. 2008-1124, the apparatus collects sounds generated from the vehicle and effects a sound signal processing thereon and emits a processed sound. With this, the presence of the vehicle is notified to a person present in the surrounding in such a manner as not to cause acoustic nuisance.

However, the technique disclosed in Japanese Unexamined Utility Model Publication No. Hei, 6-70098 emits a dummy sound of e.g. an engine sound of an engine powered automobile, a music, a chime, etc. as a sound alarming to the outside of the vehicle and the technique disclosed in Japanese Unexamined Patent Application Publication No. 2008-1124 emits a sound which will not cause acoustic nuisance to a person present in the surrounding.. Yet, only by hearing such sounds above, the person present in the surrounding will find it not easy to intuitively grasp at what speed the electrically powered automobile or vehicle is traveling.

The, there is a need for an alarming apparatus capable of allowing a person in a surrounding to intuitively grasp at what speed the moving body is traveling.

Such alarming apparatus can comprise:
a speed information acquisition section mounted on a moving body on which a person rides and configured to acquire speed information indicative of a moving speed of the moving body;
a walking pace calculation section for calculating a walking pace with using the speed information, the walking pace comprising a number of steps per unit period when a person moves with a periodical motion at the moving speed;
an alarming cycle setting section for setting an alarming cycle for alarming the presence of the moving body to the surrounding, based on the walking pace; and
an alarming section for effecting alarming by the set alarming cycle.

With the above-described configuration, it becomes possible to alarm presence of a moving body to a person present in the surrounding and also to allow the person to intuitively grasp the moving speed of the moving body. Further, if there is a person who walks along the moving body for instance, even in a very congested pedestrian space, the walking person can intuitively grasp the moving speed of the moving body by alarming from the moving body. Thus, it possible for the walking person and the moving body to make their paces (moving paces) in agreement while both facing forward. Therefore, smooth communication can be made while moving and flow of the pedestrian space can proceed in a smooth manner also.

Further, preferably, there is provided an alarming cycle table which divides the moving speed in preset segments and stores the alarming cycle for each segment; and the alarming cycle setting section sets the alarming cycle based on the alarming cycle table.

With the above-described arrangement, with acquisition of the speed information indicative of a moving speed of the moving body, the alarming cycle can be set easily. Therefore, the calculation load relating to the calculation of the alarming cycle can be alleviated.

Further, preferably, the alarming cycle defines an alarming period for effecting alarming and a resting period for resting alarming in one cycle.

With the above-described arrangement, the alarming timing can be set in advance, so that by e.g. setting the alarming cycle for each situation, the alarming section effect alarming in an appropriate manner.

Further, preferably, the alarming section effects the alarming by a sound according to a person riding on the moving body.

With the above-described arrangement, only by hearing the sound outputted from the alarming section, a person present in the surrounding of the moving body can recognize a person riding on the moving body.

Next, an alarming apparatus 2 having the function of alarming presence and a moving speed of a moving body to the surrounding will be explained.

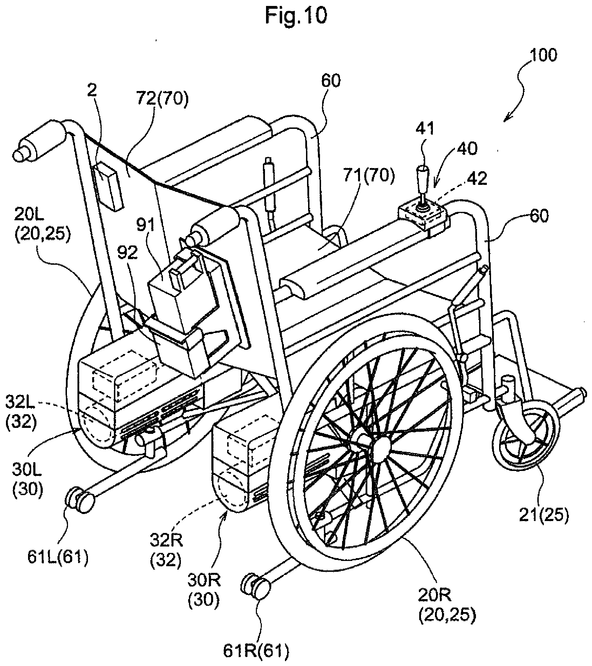

The alarming apparatus 2 is mounted on a moving body. Here, the term "moving body" refers to a vehicle on which a person can ride and corresponds, in this embodiment, to an electrically powered wheelchair 100. Thus, in the following discussion, the moving body will be explained as an electrically powered wheelchair 100. Fig 10 shows a perspective view of the electrically powered wheelchair 100 on which the alarming apparatus 2 is mounted. As shown in Fig. 10, the electrically powered wheelchair 100 includes a seat section 70, drive wheels 20, drive sections 30 and a control box 40.

The seat section 70 is mounted as being stretched in a vehicle width direction. The seat section 70 includes a seating portion 71 on which a passenger is to be seated, and a backrest portion 72 against which the passenger seated on the seating portion 71 rests his/her back. And, these portions, i.e. the seating portion 71 and the backrest portion 72 are attached to frames 60 provided on opposed outer sides in the vehicle width direction constituting a vehicle body. The electrically powered wheelchair 100 is foldable along the vehicle width direction for readiness of its storage and transport. Thus, the seating portion 70 is formed of a sheet of fabric, vinyl or the like that can be folded.

The electrically powered wheelchair 100 includes fourth wheels 25. These four wheels 25 consist of two casters 21 and two drive wheels 20. The casters 21 are provided on the front side in an advancing direction of the electrically powered wheelchair 100. Here, the term "advancing direction" means the direction in which the electrically powered wheelchair 100 travels forwardly. The casters 21 are provided in a pair of left and right casters disposed to be opposed to each other along the wheel width direction. Incidentally, in Fig. 10, illustration of the left caster 21 is omitted.

The drive wheels 20 are provided on the rear side in the advancing direction of the electrically powered wheelchair 100. The drive wheels 20 consist of a pair of left drive wheel 20L and right drive wheel 20R disposed to be opposed to each other along the outer sides in the vehicle width direction of the seating portion 70. In the following discussion, unless distinction therebetween is particularly needed, these will be referred to just as "drive wheels 20". The drive wheels 20 are wheels to which power for propelling the electrically powered wheelchair 100 is transmitted. On the other hand, in the present embodiment, the casters 21 receive no such power and are provided only for supporting a front portion of the electrically powered wheelchair 100. Further, in order to prevent collapsing of the seating portion 70 to the rear side in the advancing direction, the electrically powered wheelchair 100 is provided with roll-over prevention bars 61L, 61R which extend rearwardly of the drive wheels 20. In the following discussion, unless distinction therebetween is particularly needed, these will be referred to as just "roll-over prevention bars 61". These roll-over prevention bars 61 act as restricting means for preventing rollover to the rear side.

The drive sections 30 drive the respective drive wheels 20 by power supplied from a battery 91. The battery 91 stores in advance an amount of electric energy as power source for the electrically powered wheelchair 100 and is mounted via a holder 92 provided on the rear face of the backrest portion 72. Here, the respective drive wheels 20 mean the left drive wheel 20L and the right drive wheel 20R. For this reason, the drive sections 30 are provided in a pair to be able to drive the left drive wheel 20L and the right drive wheel 20R independently of each other. Here, the language "independently drive" is understood to mean that the left drive wheel 20L and the right drive wheel 20R can be driven at different rotational speeds and/or different rotational directions from each other. To this end, the drive sections 30 consist of a pair of left drive section 30L and right drive section 30R. In the following discussion, unless distinction therebetween is particularly needed, these will be referred to just as "drive sections 30".

The left drive section 30L includes a motor 32L for outputting a rotational force for rotating the left drive wheel 20L. Also, the right drive section 30R includes a motor 32R for outputting a rotational force for rotating the right drive wheel 20R. In the following discussion, unless distinction therebetween is particularly needed, these will be referred to as just "motors 32". The left drive section 30L and the right drive section 30R respectively receive electric energy outputted from the above-described battery 91 for driving the left drive wheel 20L and the right drive wheel 20R respectively and independently of each other.

The control box 40 includes a joystick 41 and a controller 42. The joystick 41 is mounted vertically under its neutral state extending perpendicularly upwards. From this state, as a passenger collapses it to a predetermined direction, the electrically powered wheelchair 100 can be guided in that direction. Further, according to an angle of the collapsing from the perpendicular upward, a moving speed is set. Therefore, the joystick 41 functions as an input device for inputting a passenger's intension. The controller 42 instructs an input to the joystick 41 to the drive section 30 described above. Accordingly, the controller 42 functions as a speed instruction section for instructing a set moving speed to the drive section 30. The left drive section 30L and the right drive section 30R constituting the drive section 30 drive the motor 32L and the motor 32R respectively in accordance with a drive instruction relating to traveling control inputted via the joystick 41.

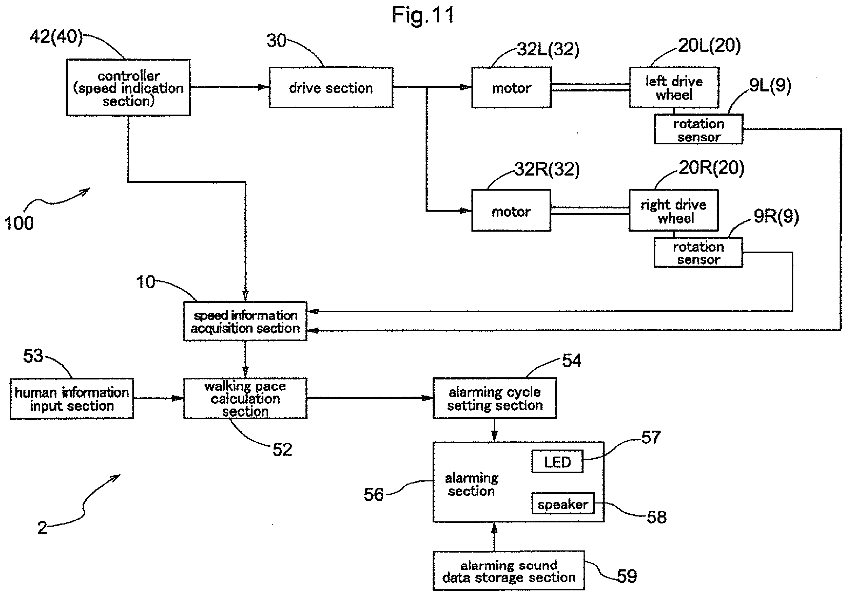

Next, the alarming apparatus 2 will be explained. Fig 11 is a block diagram showing a configuration of the alarming apparatus 2. The alarming apparatus 2 includes respective functional sections consisting of a speed information acquisition section 10, a walking pace calculation section 52, an alarming cycle setting section 54 and an alarming section 56, and these functional sections are constituted of a hardware and/or software having a CPU as a core component thereof for executing a processing relating to alarming of presence of the electrically powered wheelchair 100. Incidentally, Fig.11 shows the drive wheels 20, the drive sections 30, the motors 32 and the controller 42 also.

The speed acquisition section 10 is mounted on the electrically powered wheelchair 100 and acquires speed information indicating of a moving speed of this electrically powered wheelchair 100. Such moving speed is detected based on a rotational speed of the drive wheels 20. Here, as described above, the electrically powered wheelchair 100 includes the left drive wheel 20L and the right drive wheel 20R which are driven independently of each other. For this reason, the left drive wheel 20L and the right drive wheel 20R are not always rotated in a same manner. Thus, in this embodiment, there are provided a rotation sensor 9L for detecting a rotational speed of the left drive wheel 20L and a rotation sensor 9R for detecting a rotational speed of the right drive wheel 20R. In the following discussion, unless distinction therebetween is particularly needed, these will be referred to just as "rotation sensors 9". The speed information acquisition section 10 receives transmission of detection results of rotational speeds of the left drive wheel 20L and the right drive wheel 20R obtained respectively by the rotation sensor 9L and the rotation sensor 9R and then detects (calculates) a moving speed of the electrically powered wheelchair 100 with using these rotational speeds. Then, the speed information acquisition section 10 transmits the detected moving speed as speed information to the walking pace calculation section 52 to be described later.

Here, as described above, the controller 42 functions as a speed instruction section for instructing a set moving speed according to an operation to the joystick 41 to the drive sections 30. Here, the speed information acquisition section 10 can alternatively be configured to acquire instruction content of moving speed by the controller 42, instead of calculating a moving speed with using the detection results of the rotation sensors 9 described above and to transmit this moving speed included in the instruction content as the speed information to the the walking pace calculation section 52 to be described later.

The walking pace calculation section 52 calculates a walking pace in case a person moves with a periodical motion at the moving speed acquired by the speed information acquisition section 10. Here, the language "a person moves with a periodical motion" means that a person moves with moving at least a part of his/her body in a periodical manner. For instance, it means a movement of a person with (accompanied by) movement of his/her legs or swinging of his/her arms, etc. Needless to say, it can be movement accompanied by swinging of the person's face or hip, etc. Further, the above language "a walking pace in case a person moves" means a walking pace of a person not when this person actually moves, but a walking pace of a person when it is assumed this person moves at the speed acquired by the speed information acquisition section 10. Here, the language "walking pace" refers to a pace at which a person moves and this comprises a number of steps per unit period, in this embodiment. Incidentally, in this embodiment, the term "walking pace" is understood to mean not only the pace of person's walking, but also the pace of the person's running.

Here, it is noted that the walking pace (a number of steps per unit period) at the time of a person's walking or running differs depending on such factors as a body height, age, sex of the person. For instance, in case the alarming apparatus 2 effects alarming in correspondence with the person riding on the electrically powered wheelchair 100, advantageously, the alarming apparatus 2 can be provided with a human information inputting section 53 in order to indicate what kind of person is riding. Then, a body height, age, sex of the person riding on the electrically powered wheelchair 100 will be inputted by the human information inputting section 53 described above and can be transmitted therefrom to the walking pace calculation section 52. In this case, the walking pace calculation section 52 can calculate the walking pace according to such person's height, age, sex, etc.

Here, a person's walking speed is determined by a product of a stride (step length) and a walking pace. In this regard, it is said that a stride has generally a value obtained by subtracting 100 cm from the person's height. The "walking pace" means a number of steps per unit period (1 second) as described above. Therefore, the walking pace calculation section 52 calculates a walking pace by dividing a moving speed included in the speed information transmitted from the speed information acquisition section 10 by a stride according to the height and sex of the person riding on the electrically powered wheelchair 100. And, a reciprocal number of the result of this calculation becomes the leg swinging cycle of the person when he/she moves.

The alarm cycle setting section 54 sets an alarming cycle for alarming the presence of the electrically powered wheelchair 100 to the surrounding based on the walking pace calculated by the walking pace calculation section 52. The alarming cycle setting section 54 sets the leg swinging (feeding) cycle calculated by the walking pace calculation section 52 as the alarming cycle. When the presence of the electrically powered wheelchair 100 is alarmed to the surrounding, this alarming can be effected by output of a sound or flashing of LED, etc. Needless to say, the alarming can be effected by using both of them also. The "alarming cycle" refers to the cycle at which the alarming apparatus 2 alarms the presence of the electrically wheelchair 100 to the surrounding. Further, in the instant embodiment, by the alarming cycle, there are defined an alarming period for effecting alarming and a resting period for resting the alarming, in one cycle. In the case of alarming by sound output, the period of outputting a sound becomes the alarming period, and the period when outputting of sound is stopped becomes the resting period, in one cycle respectively. Whereas, in the case of alarming by way of flashing of LED, or the like, the period of flashing the LED or the like becomes the alarming period and the period of stopping flashing of the LED or the like becomes the resting period, in one cycle. The alarming cycle set by the alarming cycle setting section 54 is transmitted to the alarming section 56 to be described later.

The alarming section 56 effects alarming by the alarming cycle set by the alarming cycle setting section 54. The method of alarming by the alarming section 56 can be the form of flashing of LED 57 or the like or outputting of sound from a speaker 58. For instance, in the case of flashing the LED 57 or the like, the LED can be flashed by the alarming period set by the alarming period setting section 54.

Further, in the case of outputting a sound from the speaker 58 for instance, advantageously, alarming sounds can be stored in advance in an alarming sound data storage section 59, so that the alarming section 56 selects, from this alarming sound data storage section 59, a sound corresponding to a person riding on the electrically powered wheelchair 100 and outputs this selected sound by the alarming cycle set by the alarming cycle setting section 54.

Here, "a sound corresponding to a person riding on the electrically powered wheelchair 100" can be a sound corresponding to or according to the sex, age of the riding person. Namely, in case the riding person is a child, the sound can be set as a sound simulating a light skipping of a child, for instance. Whereas, in case the riding person is a grownup male, the sound can be provided with emphasis of low frequency. And, in case the riding person is a grownup female, the sound can be provided with emphasis of high frequency. With such arrangements as above, when hearing the sound, a person present in the surrounding of the electrically powered wheelchair 100 can readily identify the kind of the person riding on the electrically powered wheelchair 100, without visual confirmation thereof.

Incidentally, the flashing of the LED 57 or periodical output of sound effected by the alarming section 56 can be effected in the form of illuminating the LED 57 or sound outputting from the speaker 58 only at predetermined timing or can also be effected in the form of extinguishing the LED 57 which is normally illuminated or muting the sound which is normally outputted, by the alarming cycle.

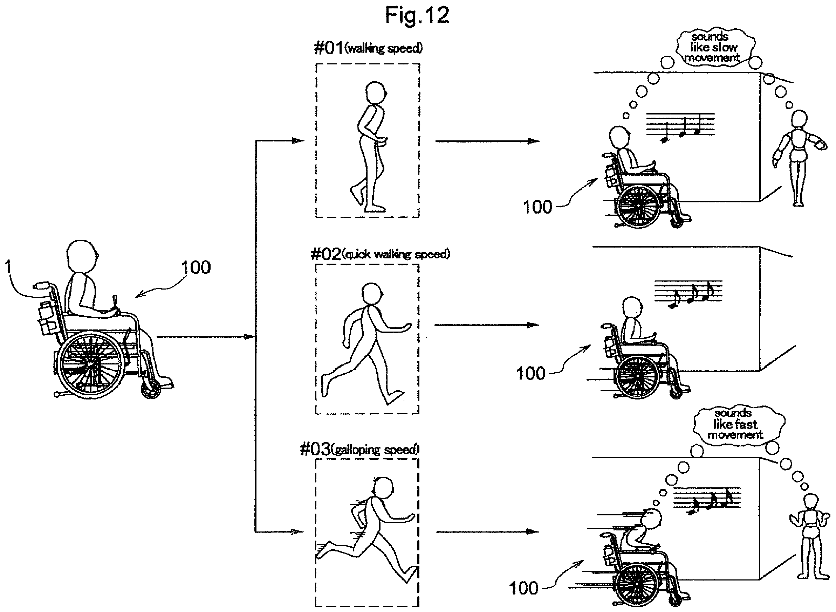

Fig. 12 shows an example of a case in which the alarming cycle is divided into three kinds. Namely, in the example shown, there are provided a case when the walking pace calculation section 52 calculates a moving speed of the electrically powered wheelchair 100 as a speed similar to a walking speed of a person (#01), a case when the walking pace calculation section 52 calculates a moving speed of the electrically powered wheelchair 100 as a speed similar to quick walking of a person (#02), and a case when the walking pace calculation section 52 calculates a moving speed of the electrically powered wheelchair 100 as a speed similar to a galloping of a person (#03). In such case, it is possible to arrange such that a length of sound (a quarter note) outputted in the case of #01, a length of sound (an eighth note) outputted in the case of #02, and a length of sound (a sixteenth note) outputted in the case of #03 are made different from each other. By varying the length of outputted sound, it is possible for the moving speed of the electrically powered wheelchair 100 to be intuitively grasped by a person present in the surrounding.

With the above arrangement, in case the moving speed of the electrically powered wheelchair 100 is low, even if the electrically powered wheelchair 100 is present in a blind spot to be not readily visible, its presence can be informed in advance to a person present in the blind spot, thus giving the person feel of security. Conversely, in case the moving speed of the electrically powered wheelchair 100 is high, even if the electrically powered wheelchair 100 is present in a blind spot to be not readily visible, its presence can be informed to a person present in the blind spot in advance. As a result, it is possible to cause the person to hesitate to rush out at a crossroad or to cause the person to make a stop there. Furthermore, the electrically powered wheelchair 100 is not equipped with a speedometer in many cases. In such case too, it is possible to cause the person riding on the electrically powered wheelchair 100 to intuitively grasp the moving speed of the electrically powered wheelchair 100.

Incidentally, in the above-described variation, the explanation was made with citing the electrically powered wheelchair 100 as an example of the moving body. However, the moving body can be any other vehicle as long as a person can ride on it. For instance, it can be an electrically powered vehicle, a hybrid vehicle, a Personal Mobility, a bicycle, a non electrically powered wheelchair, or any other vehicle with which it is difficult for a person present in its surrounding to grasp its presence by hearing a sound emitted therefrom during its run.

Further, it was explained that the alarming cycle defines an alarming period and an alarming resting period in one cycle of alarming. However, in case such alarming period and such alarming resting period in one cycle are set in advance, the alarming cycle can define only the timing of alarming.

Further, in the above, it was explained that the alarming section 56 effects alarming by a sound corresponding to the person riding on the electrically powered wheelchair 100. Instead, the alarming section 56 can be configured to effect alarming by a same sound, irrespectively of the person riding on the electrically powered wheelchair 100.

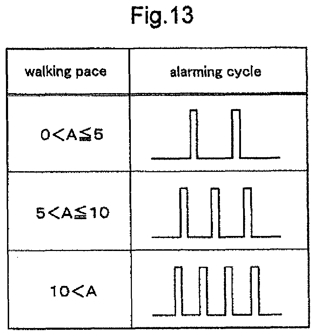

Further, in the above, it was explained that the alarming cycle setting section 54 sets the leg swinging (feeding) cycle calculated by the walking pace calculation section 52 as the alarming cycle. Alternatively, with division of the moving speed into preset sections, the alarming cycle setting section 54 can be configured to set the alarming cycle by each such section. In this case, advantageously, there is provided an alarming cycle table which divides the moving speed in preset segments and stores the alarming cycle for each segment. Fig. 13 shows one example of such alarming cycle table. In the case of the example shown in Fig. 13, if the moving speed is A km/h, the alarming cycle is divided into three sections of: a case of 0 <A ≦5 km/h, a case of 5 <A ≦ 10 km/h, a case of <10 km/h and the alarming cycle is defined for each section. More specifically, for a segment of a high moving speed, there is set faster alarming cycle. Namely, if the timing of output of a sound or a light is represented by a pulse, the higher moving speed of the segment, the greater the number of pulses per unit period. Then, the alarming cycle setting section 54 can be configured to set the alarming cycle based on such alarming cycle table. Needless to say, the above-described division into three segments is only exemplary, division into two segments or four or more segments is also possible.

Further, in case the moving speed of the electrically powered wheelchair 100 included in the speed information acquired by the speed information acquisition section 10 is such a moving speed at which moving by human legs is not possible (e.g. the speed is too high), the alarming apparatus 2 can effect alarming in a continuous manner.

Also, in the above, it was explained that the alarming section 56 selects and outputs a sound stored in the alarming sound data storage section 59 in advance as an alarming sound. Alternatively, this sound can be a motor sound or an engine sound which is recorded in advance. Further, it can be a random noise such as white noise or pink noise produced by a signal processing/statistic processing software or can also be a voice guidance by a narrator. Further alternatively, the alarming apparatus 2 can be equipped with a microphone, so that a running sound or motor sound, etc. picked up by the microphone in real time may be used as the sound.

Such alarming apparatus as described above can be used as an alarming apparatus for alarming presence of a moving body ridden by a human to its surrounding.

Such alarming apparatus can be described as follows.

Namely, the alarming apparatus can comprise:
a speed information acquisition section mounted on a moving body on which a person rides and configured to acquire speed information indicative of a moving speed of the moving body;
a walking pace calculation section for calculating a walking pace with using the speed information, the walking pace comprising a number of steps per unit period when a person moves with a periodical motion at the moving speed;
an alarming cycle setting section for setting an alarming cycle for alarming the presence of the moving body to the surrounding, based on the walking pace; and
an alarming section for effecting alarming by the set alarming cycle.

Further, the alarming apparatus comprises an alarming cycle table which divides the moving speed in preset segments and stores the alarming cycle for each segment; and
the alarming cycle setting section sets the alarming cycle based on the alarming cycle table.

Further, the alarming apparatus can be configured such that the alarming cycle defines an alarming period for effecting alarming and a resting period for resting alarming, in one cycle.

Further, the alarming apparatus can be configured such that the alarming section effects the alarming by a sound according to a person riding on the moving body.

### Industrial Applicability

The present invention is applicable to a sound volume control apparatus for controlling a volume of a sound emitted from a moving body.

### Description Reference Marks/Numerals

- 1:: sound volume control apparatus
- 11:: sound acquisition section
- 12:: storage section
- 13:: calculation section
- 15:: trend component calculation section
- 16:: prediction section
- 17:: sound volume setting section
- 18:: alarming section
- 19:: trough state determination section
- 100:: electrically powered wheelchair (moving body)

## Claims

1. A sound volume control apparatus comprising:
a sound acquisition section provided in a moving body to be ridden by a human for acquiring a sound in a surrounding of the moving body;
a storage section for storing a sound acquired by the sound acquisition section as sound data;
a calculation section for calculating time change in volume of the sound acquired in a period from a predetermined first past timing to the present, with using the sound data;
a sound volume setting section for setting a volume of an alarming sound based on result of the calculation in the calculation section; and
an alarming section for effecting alarming in the volume set by the sound volume setting section.

2. The sound volume control apparatus of claim 1, wherein:
there is provided a trough state determination section configured to determine it as a trough state in the time change if a state of the volume of sound being below an alarming sound audible threshold value has continued for a preset second period, the alarming sound audible threshold value being set in advance according to a volume, at least audible by the person, of the alarming sound to be emitted from the moving body; and
the alarming section effects the alarming if the trough state determination section determines the trough state.

3. The sound volume control apparatus of claim 2, wherein the trough state determination section stops the determination of trough state for a preset third period from the present in case the alarming section has effected the alarming.

4. The sound volume control apparatus of claim 2 or 3, wherein the alarming section effects the alarming if the volume of sound in the surrounding of the moving body is below the alarming sound audible threshold value.

5. The sound volume control apparatus of any one of claims 2-4, wherein the alarming section effects the alarming in the volume set by the sound volume setting section when absence of the alarming sound has continued in a period from a preset fourth past timing to the present.

6. The sound volume control apparatus of any one of claims 1-5, wherein the apparats further comprises:
a trend component calculation section for calculating a trend component indicative of varying trend in the volume of the sound which varies over time, with using the sound data;
a prediction section for predicting a volume of sound present in future in the surrounding of the moving body based on the trend component, in case a time change in the volume of the sound is greater than a preset predetermined value; and
wherein the sound volume setting section sets the volume of the alarming sound based on the result of prediction by the prediction section.

7. The sound volume control apparatus of claim 6, wherein:
the trend component calculation section calculates two trend components different from each other; and
the sound volume setting section sets the volume of the alarming sound in accordance with the volume of the sound in the surrounding of the moving body which is predicted based on the two trend components.

8. The sound volume control apparatus of claim 6 or 7, wherein the sound volume setting section sets the volume of the alarming sound based on a volume of a present sound acquired by the sound acquisition section and a volume of the present sound predicted in the past by the prediction section.

9. The sound volume control apparatus of any one of claims 6-8, wherein the sound volume setting section sets the volume of the alarming sound to a maximum value of rated output of the alarming section when the volume of alarming sound set based on the result of prediction by the prediction section exceeds the rated output of the alarming section.

10. The sound volume control apparatus of any one of claims 1-9, wherein the sound volume setting section maintains the volume of the alarming sound at the present volume if the time change of the sound volume is below a preset predetermined value.
